# EUROPEAN PATENT SPECIFICATION

(11) **EP 2 645 567 B1**
(45) Date of publication and mention of the grant of the patent: **07.01.2015**
(21) Application number: 13152543.8
(22) Date of filing: 24.01.2013
(51) Int. Cl.: H03G 3/30

(54) **Volume control apparatus**
Lautstärkesteuerung
Appareil de commande de volume

(30) Priority: 30.03.2012 JP 2012081383
(43) Date of publication of application: 02.10.2013
(73) Proprietor: Kabushiki Kaisha Toshiba, Tokyo 105-8001 (JP)
(72) Inventor: Okuhara, Kentaro, Tokyo 105-8001 (JP)
(74) Representative: Henkel, Breuer & Partner

(56) References cited:
- WO-A2-99/26337
- US-A1- 2007 177 743
- US-A1- 2011 029 874

## Description

### FIELD

An embodiment described herein relates generally to a volume control apparatus.

### BACKGROUND

In recent years, remarkable progress has been made in techniques for processing video and audio digital signals, which has been accompanied by realization of digital broadcasting and system development for promoting not only broadcasting but also use of services through communication. Furthermore, such television receivers are also conceived that are equipped with not only a function of processing and displaying video content acquired through broadcast reception or the like (hereinafter referred to as "TV function") but also a function of accessing the Internet and executing various applications, enabling users to access the Internet and engage in conversation using a Skype (registered trademark) telephone.

In such television receivers, audio in video content is outputted as main audio and incoming audio in a Skype telephone is outputted as sub-audio. Such television receivers are configured to be able to receive an incoming call in the Skype telephone even while viewing video content.

In this case, a volume setting for a ring tone of the Skype telephone may be considered the same as a volume setting for main audio based on the video content. In such a case, when sub-audio such as the ring tone of the Skype telephone is superimposed on the main audio based on the video content and acoustically outputted, the presence of the main audio may make it difficult to hear the ring tone.

However, no apparatus has been conventionally developed which could automatically adjust the volume of sub-audio to an optimum volume with respect to the volume of main audio.

WO 99/26337 A2 discloses a signal regulator regulating an auxiliary signal based upon a primary signal level scaled by an external amplifier. The signal regulator receives the primary signal with an unscaled level. Processing circuitry monitors the unscaled level of the primary signal. The primary signal is then output to the external amplifier for scaling, either by amplification or attenuation. The primary signal with a scaled level is in turn received by the signal regulator from the amplifier. The processing circuitry monitors the scaled level of the primary signal from the amplifier, and then generates a gain factor based upon the unscaled level and the scaled level of the primary signal. An auxiliary signal is received by the signal regulator. Adjusting circuitry receives the gain factor from the processing circuitry and adjusts a level of the auxiliary signal based upon the gain factor. The auxiliary signal with the adjusted level is then provided to an external component, for example, a loudspeaker.

US 2007/177743 A1 discloses a device arranged for controlling the sound levels of a group of audio channels including a user selected main channel and at least one auxiliary channel, wherein the audio channels can be rendered simultaneously. The device comprises automatic level adjustment means for adjusting the sound level of the at least one auxiliary channel relative to the main channel. The level adjustment means may be arranged for adapting the respective sound levels to the content or signal characteristics of each associated audio channel.

### BRIEF DESCRIPTION OF THE DRAWINGS

Fig. 1 is a block diagram illustrating a volume control apparatus according to an embodiment of the present invention;
Fig. 2 is a block diagram illustrating a television receiver incorporating the volume control apparatus of the present embodiment; and
Fig. 3A and Fig. 3B are waveform diagrams illustrating operation of the embodiment.

### DETAILED DESCRIPTION

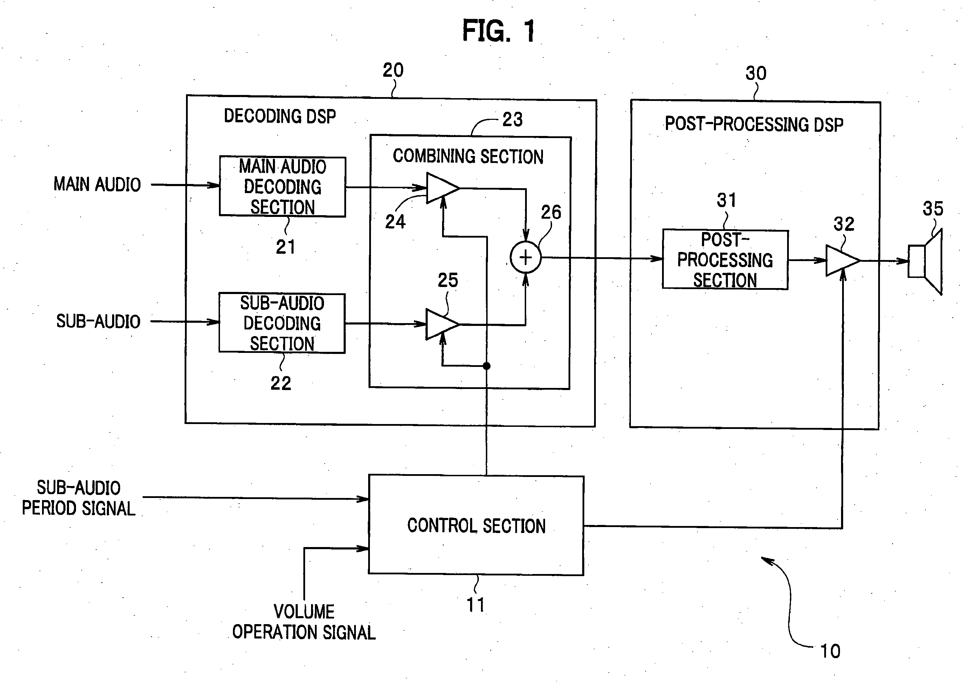

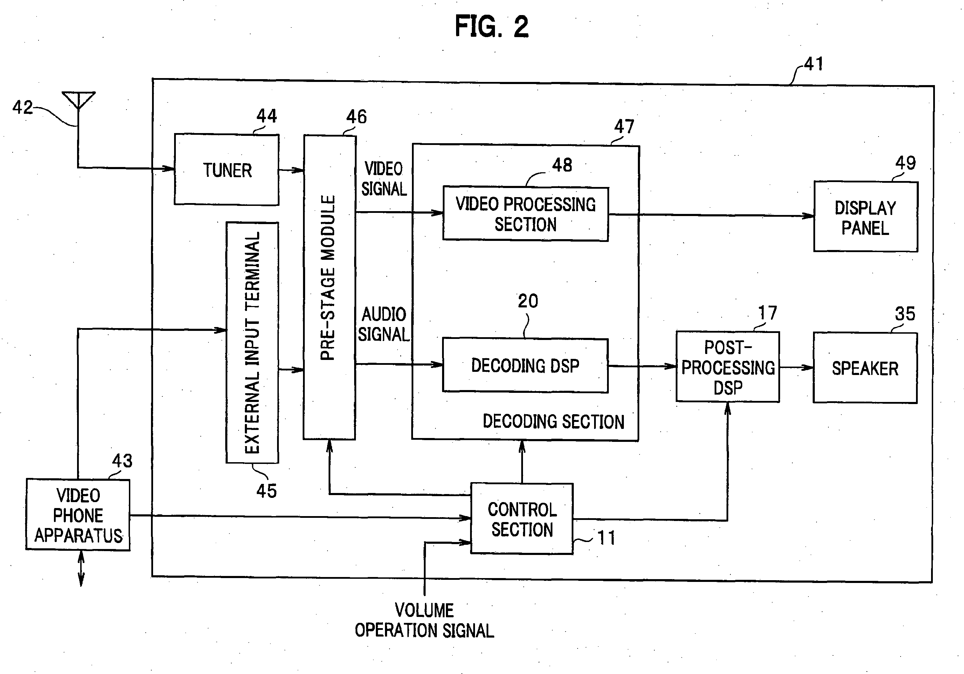

Hereinafter, an embodiment of the present invention will be described in detail with reference to the drawings. Fig. 1 is a block diagram illustrating a volume control apparatus according to an embodiment of the present invention. Fig. 2 is a block diagram illustrating a television receiver incorporating the volume control apparatus of the present embodiment.

Referring to Fig. 2, a television receiver 41 incorporating the volume control apparatus of the present embodiment will be described first. Note that the present embodiment is applicable not only to a television receiver but also to a variety of apparatuses handling audio signals.

In Fig. 2, in addition to a television signal induced to an antenna 42, a signal from a video phone apparatus 43 is also inputted to the television receiver 41. The video phone apparatus 43 may be incorporated in the television receiver 41. The video phone apparatus 43 transmits/receives a video phone signal via a network (not shown) such as the Internet. Fig. 2 shows only an input system from the video phone apparatus 43. A video signal and audio signal such as a ring tone and sound of audio from the video phone apparatus 43 are inputted to a pre-stage module 46 via an external input terminal 45. Furthermore, the video phone apparatus 43 generates a sub-audio period signal indicating a period during which a ring tone is generated and outputs the sub-audio period signal to a control section 11.

A tuner 44 tunes/processes a broadcasting signal of satellite broadcasting such as BS broadcasting and CS broadcasting, terrestrial broadcasting or the like and outputs a video signal and audio signal based on received video content to the pre-stage module 46. The tuner 44 can also receive a signal from a communication channel such as a cable TV channel.

The pre-stage module 46 receives a plurality of video signals/audio signals or the like from the tuner 44 and the external input terminal 45 as input, selects any one of video signals/audio signals and performs pre-stage processing. The pre-stage module 46 has, for example, an A/D conversion function of converting an analog video signal to a digital signal and a chroma format conversion function of performing chroma format conversion. The pre-stage module 46 outputs the video signal after the pre-stage processing to a video processing section 48 of a decoding section 47 and outputs the audio signal to a decoding DSP 20.

The video processing section 48 decodes the inputted video signal and then applies predetermined video signal processing thereto. The video signal from the decoding section 47 is outputted to a display panel 49 as a display video signal. Thus, video based on video content and video based on the video phone are displayed on a display screen of the display panel 49.

On the other hand, the decoding DSP 20 together with a post-processing DSP 17 applies decoding processing, volume control processing, predetermined audio signal processing or the like to the inputted audio signal and then outputs the processed audio signal to a speaker 35. Thus, the speaker 35 acoustically outputs audio based on the video content and audio based on the video phone.

The control section 11 controls the pre-stage module 46, the decoding section 47 and the post-processing DSP 17. In the present embodiment, it is thereby possible to automatically adjust the volume of sub-audio to an optimum volume with respect to the volume of main audio.

Japanese Patent Application Laid-Open Publication No. 2006-184423 (hereinafter referred to as "Document 1 ") discloses an apparatus that performs volume control mainly in a car navigation system. The apparatus according to Document 1 is provided with a DSP that operates through software processing and an electronic volume circuit. While no guide audio signal is inputted, the apparatus according to Document 1 performs volume control over main audio through the electronic volume circuit. On the other hand, while a guide audio signal is inputted, the apparatus performs volume control over main audio through the DSP, mixes the guide audio signal with the volume-adjusted main audio and then performs volume control over the whole signal through the electronic volume circuit.

However, since the apparatus according to Document 1 mixes sub-audio with the volume-adjusted main audio, volume control using the electronic volume is necessary to perform variable control over the volume of sub-audio, instead of a specific volume. However, since the volume of main audio is also changed by this control, it is necessary to also perform volume control over the DSP according to volume control over the electronic volume to adjust the main audio and sub-audio to desired volumes, which results in a problem that the processing becomes complicated.

On the other hand, Japanese Patent Application Laid-Open Publication No. 2011-149852 (hereinafter referred to as "Document 2") discloses a navigation apparatus that simply and speedily sets the volume of guide audio to a desired value. The apparatus according to Document 2 is provided with control means for performing control to change the volume of guide audio for path guiding means by a variation corresponding to the amount of operation of volume adjustment operating means for a period of guide audio output by the path guiding means. With the apparatus according to Document 2, when a user misses hearing sub-audio, the volume of sub-audio is reset through user operation. This allows the user to hear sub-audio with the reset audio.

However, with the apparatus according to Document 2, the user needs to manually adjust the volume of sub-audio to hear sub-audio with a desired volume, which is a complicated operation.

In contrast, according to the present embodiment, the user needs only to perform volume control over main audio based on video content. In the present embodiment, the volume of sub-audio is set so as to be changed in a predetermined relation to main audio and the volume of sub-audio is always automatically adjusted to an optimum volume.

In Fig. 1, main audio and sub-audio are inputted to the decoding DSP 20. The main audio is, for example, audio corresponding to video content displayed by a television receiver or sound of audio of a video phone. For example, the main audio is an audio signal of the MPEG2 AAC standard and a main audio decoding section 21 decodes the inputted main audio and outputs, for example, a PCM standard audio signal.

On the other hand, the sub-audio is an audio signal inputted independently of the main audio and is, for example, a ring tone of a video phone. A sub-audio decoding section 22 decodes the inputted sub-audio and outputs, for example, a PCM standard audio signal. Note that when a PCM standard signal is inputted as the sub-audio, the decoding DSP 20 outputs the inputted PCM standard signal as is.

The audio signal from the main audio decoding section 21 is supplied to an amplifier 24 of a combining section 23 and the audio signal from the sub-audio decoding section 22 is supplied to an amplifier 25 of the combining section 23. With amplification factors controlled by amplification control signals from the control section 11, the amplifiers 24 and 25 amplify main audio and sub-audio respectively, and output the amplified audio. The outputs of the amplifiers 24 and 25 are supplied to an adder 26, and the adder 26 adds up the main audio and sub-audio from the amplifiers 24 and 25 and outputs the addition result.

The control section 11 can control amplification factors of the amplifiers 24 and 25 independently and the combining section 23 amplifies the inputted main audio and sub-audio based on the amplification control signal from the control section 11, combines the amplified main audio and sub-audio and outputs the combined audio.

The audio signal from the combining section 23 is supplied to a post-processing section 31 in a post-processing DSP 30. The post-processing section 31 applies predetermined audio signal processing, for example, sound quality improvement processing to the inputted audio signal. The audio signal from the post-processing section 31 is given to an amplifier 32. The amplifier 32 which is a master amplification section amplifies the audio signal inputted based on an amplification control signal from the control section 11 and outputs the amplified audio signal to a speaker 35. Thus, the speaker 35 acoustically outputs the main audio, sub-audio or a combined audio of main audio and sub-audio.

In the present embodiment, the amplification factors of the respective amplifiers 24 and 25 of the combining section 23 and the amplification factor of the amplifier 32 of the post-processing DSP 30 are controlled by the control section 11. The control section 11 sets amplification control signals to be given to the amplifiers 24 and 25, and the amplifier 32 as appropriate to thereby automatically adjust the volume of sub-audio to an optimum value in accordance with the volume of main audio.

The control section 11 receives a sub-audio period signal indicating the period during which sub-audio is inputted. When, for example, the sub-audio is a ring tone of a video phone, the sub-audio period signal indicates a ring tone input period. The control section 11 receives a volume operation signal based on a volume operation by the user as input. Note that the volume operation by the user is intended to control the volume of audio or sound of audio corresponding to video content currently being watched.

In the present embodiment, the control section 11 controls the volume of main audio in accordance with a volume operation by the user and also performs volume control over sub-audio based on the volume control over main audio.

For a period during which sub-audio is not inputted and only main audio is inputted (hereinafter referred to as "main audio period"), the control section 11 controls the amplification factor of the amplifier 32 of the post-processing DSP 30 based on the volume operation by the user and, thereby performs amplification processing on the main audio so that the volume of main audio is a volume the use desires.

On the other hand, for a period during which both main audio and sub-audio are inputted (hereinafter referred to as "main and sub-audio period"), the control section 11 controls the amplification factor of the amplifier 24 of the combining section 23 of the decoding DSP 20 and the amplification factor of the amplifier 32 of the post-processing DSP 30 in accordance with the volume operation by the user, and thereby controls the volume of main audio so as to be a volume the use desires.

Furthermore, for the main and sub-audio period, the control section 1I automatically adjusts the amplification factor of the amplifier 25 of the combining section 23 of the decoding DSP 20 based on the amplification factors of the amplifier 24 and amplifier 32, that is, a total amplification factor corresponding to the main audio, and thereby automatically adjusts the volume of sub-audio appropriately to ensure that the user hears sub-audio such as a ring tone.

To enable such control, the control section 11 performs the following controls (a) to (d) for the main and sub-audio period.
(a) The amplification factor of the amplifier 32 of the post-processing DSP 30 is set to a sufficiently high fixed amplification factor so as to set the volume of sub-audio to a sufficient volume. Furthermore, the amplification factor of the amplifier 25 of the combining section 23 of the decoding DSP 20 is set to a predetermined amplification factor. Thus, the total amplification factor of sub-audio is set to a fixed first amplification factor or a second amplification factor (variable) equal to or higher than the first amplification factor.
   That is, when the total amplification factor of main audio for the main audio period is equal to or lower than a fixed third amplification factor (first amplification factor > third amplification factor), the total amplification factor of sub-audio is set to the first amplification factor, and when the total amplification factor of main audio for the main audio period is a fourth amplification factor (variable) equal to or higher than the third amplification factor (second amplification factor > fourth amplification factor), the total amplification factor of sub-audio is set to the second amplification factor. This allows the output volume of the sub-audio to be set to equal to or higher than a predetermined volume. Note that the second to fourth amplification factors may also be set to a predetermined value.
(b) When the amplification factor of the amplifier 32 of the post-processing DSP 30 is increased through the control (a), the total amplification factor of main audio at the start of the main and sub-audio period is maintained by reducing the amplification factor of the amplifier 24 of the combining section 23. Thus, if there is no volume operation by the user, the volume of main audio does not change between the main audio period and the main and sub-audio period.
   The control (a) and (b) allows the volume of sub-audio to be set to a volume equal to or higher than a maximum volume estimated for main audio.
(c) When the user performs volume operation to increase the volume of main audio after the main and sub-audio period starts, the amplification factor of the amplifier 24 of the combining section 23 is increased in response to this volume operation.
(d) As a result of the control (c), if the total amplification factor of main audio becomes the fourth amplification factor which is higher than the third amplification factor, the amplification factor of the amplifier 25 is increased by (fourth amplification factor minus third amplification factor) and the total amplification factor of sub-audio is set to the variable second amplification factor.

Note that the first and third amplification factors may be configured to be changeable based on the user operation.

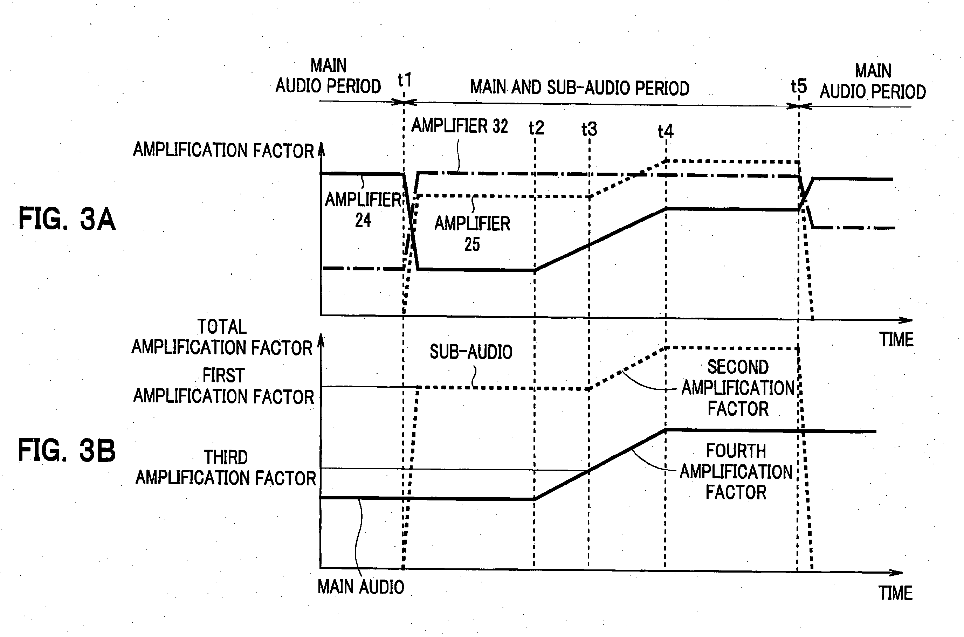

Next, the operation of the embodiment in such a configuration will be described with reference to waveform diagrams in Fig. 3A and Fig. 3B. Fig. 3A shows the control over the amplification factors of the respective amplifiers 24, 25 and 32, and Fig. 3B shows the total amplification factor of main audio and sub-audio.

Suppose the user is watching a video content tuned by the tuner 44. The decoding DSP 20 receives main audio based on the video content currently being watched by the user. Furthermore, suppose the sub-audio period signal indicates that sub-audio is not inputted. In this case, the control section 11 sets a predetermined amplification factor in the amplifier 24 of the combining section 23 and also sets an amplification factor in the amplifier 32 of the post-processing DSP 30 based on the volume operation by the user.

Thus, for the main audio period, the amplification factor of the amplifier 32 of the post-processing DSP 30 is controlled through the volume operation by the user and main audio is acoustically outputted from the speaker 35 with a volume corresponding to the volume operation by the user.

Here, suppose a call arrives at the video phone apparatus 43 and a ring tone of the video phone is inputted to the decoding DSP 20 as sub-audio at time t1 in Fig. 3A and Fig. 3B. When the sub-audio period signal indicates that the sub-audio period starts, the control section 11 sets the amplification factor of the amplifier 32 to a predetermined fixed amplification factor to secure a sufficient volume of sub-audio. Furthermore, the control section 11 increases the amplification factor of the amplifier 25 of the combining section 23 of the decoding DSP 20 so that the total amplification factor of sub-audio becomes higher than the total amplification factor of main audio.

Furthermore, the control section 11 changes the amplification factor of the amplifier 24 so that the total amplification factor of main audio becomes constant before and after the sub-audio input. In the example in Fig. 3A and Fig. 3B, the amplification factor of the amplifier 32 is increased on one hand, and the amplification factor of the amplifier 24 is decreased on the other so that the total amplification factor of main audio becomes constant.

In the example of Fig. 3A and Fig. 3B, the total amplification factor of main audio before time t1 is equal to or lower than the third amplification factor and the control section 11 sets the total amplification factor of sub-audio of the amplifiers 32 and 25 to the first amplification factor. When the total amplification factor of main audio before time t1 is the fourth amplification factor which is higher than the third amplification factor, the control section 11 sets the total amplification factor of sub-audio of the amplifiers 32 and 25 to the second amplification factor which is higher than the first amplification factor.

That is, when the main and sub-audio period starts, the total amplification factor of sub-audio becomes an amplification factor which is sufficiently high and higher than the total amplification factor of main audio, and further becomes an amplification factor higher than the total amplification factor of main audio by a predetermined amount or more. Because of this, when the main and sub-audio period starts, the volume of sub-audio becomes a volume which is sufficiently high and higher than the volume of main audio, and can further be set to a volume higher than the volume of main audio by a predetermined amount or more.

Next, suppose the user performs operation to increase the volume of main audio at timing of time t2 based on video content currently being watched. The control section 11 increases the amplification factor of the amplifier 24 in accordance with the volume operation by the user. Thus, the total amplification factor of main audio also increases.

However, since the total amplification factor of sub-audio is set to a sufficiently high value, the control section 11 maintains the amplification factors of the amplifiers 32 and 25 even when the volume operation on main audio starts and does not change the total amplification factor of sub-audio.

However, when the total amplification factor of main audio exceeds the third amplification factor to become the fourth amplification factor through the volume operation by the user, the control section 11 increases the amplification factor of the amplifier 25 following the change of the amplification factor of the amplifier 24. Fig. 3A and Fig. 3B show that the total amplification factor of main audio exceeds the third amplification factor at time t3 and the control section 11 changes the amplification factor of the amplifier 25 so that the difference in the total amplification factor between main audio and sub-audio becomes (first amplification factor minus third amplification factor). Note that since the amplifier 32 is set to a fixed amplification factor during the main and sub-audio period, it is easy to control the amplification factor of the amplifier 25.

Fig. 3A and Fig. 3B show that the volume operation by the user ends at time t4. The control section 11 stops the change of the amplification factor of the amplifier 24 and at the same time also stops the change of the amplification factor of the amplifier 25. Thus, the difference in the total amplification factor between main audio and sub-audio is kept to (first amplification factor minus third amplification factor).

Here, suppose the call for the video phone apparatus 43 stops and the sub-audio input stops at time t5. Upon detecting through the sub-audio period signal that the sub-audio input stops, the control section 11 stops the amplification of the amplifier 25 and controls the amplification factors of the amplifiers 24 and 32 so that the total amplification factor of main audio does not change. This causes the amplification factor of main audio to remain unchanged before and after returning to the main audio period.

Note that when the user operates the video phone apparatus 43 to respond to the call of the video phone, video of the video phone is supplied to the video processing section 48 and sound of audio of the video phone is supplied to the decoding DSP 20 as main audio. In this case, the volume control over main audio may also be similar to that in Fig. 3A and Fig. 3B. That is, when the user responds to the video phone, sound of audio is acoustically outputted as main audio with a volume based on the volume operation by the user, whereas when the ring tone stops without the user responding to the video phone, audio based on the video content is acoustically outputted as main audio with a volume based on the volume operation by the user.

Fig. 3A and Fig. 3B describe the example where the user performs operation of increasing the volume, but even when the user performs operation of decreasing the volume, the control over the amplification factor shown in Fig. 3A and Fig. 3B is performed in accordance with the total amplification factor of main audio.

Thus, the present embodiment can set sub-audio to a sufficient volume, and even when the volume of main audio is relatively high, the present embodiment can set the volume of sub-audio to a volume equal to or higher than that. Since the volume of sub-audio can be automatically adjusted to an optimum volume with respect to the volume of main audio, the user can hear sub-audio reliably even when main audio and sub-audio are acoustically outputted simultaneously. Moreover, the user needs only to perform volume operation for main audio and need not perform complicated operation to reliably hear sub-audio.

Furthermore, since the amplification factor of the master amplification section is set to a fixed amplification factor for the main audio and sub-audio input period, it is possible to use only one type of control pattern of amplification factors of main audio and sub-audio, and thereby simplify processing.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope of the inventions.

## Claims

1. A volume control apparatus comprising:
a main audio amplification section (24) configured to amplify inputted main audio;
a sub-audio amplification section (25) configured to amplify inputted sub-audio;
a combining section (26) configured to combine an output of the main audio amplification section (24) and an output of the sub-audio amplification section (25), to be outputted;
a master amplification section (32) configured to amplify an output of the combining section; and
a control section (11) configured to perform first amplification processing to change an amplification factor of the main audio based on a volume operation by a user by controlling the main audio amplification section and the sub-audio amplification section, and to perform second amplification processing to amplify, during a main audio and sub-audio input period, when the amplification factor of the main audio is equal to or lower than a third amplification factor, the sub-audio with a first amplification factor which is higher than the third amplification factor, and amplify, when the amplification factor of the main audio is a fourth amplification factor which is higher than the third amplification factor, the sub-audio with a second amplification factor which is higher than the first amplification factor and which changes depending on the fourth amplification factor.

2. The volume control apparatus according to claim 1,
wherein the sub-audio includes audio of a ring tone.

3. The volume control apparatus according to claim 1,
wherein, as the first amplification processing, the control section (11) is configured to amplify the main audio through the master amplification section (32) during a period in which only the main audio is inputted, and increase the amplification factor of the master amplification section and reduce the amplification factor of the main audio amplification section (24) during the main audio and sub-audio input period.

4. The volume control apparatus according to claim 1,
wherein when the amplification factor of the master amplification section (32) increases at a start of the main audio and sub-audio input period, the control section (11) is configured to control the main audio amplification section (24) to reduce the amplification factor for the main audio and maintain the volume of the main audio at the start of the main audio and sub-audio input period.

5. The volume control apparatus according to claim 1,
wherein the control section (11) is configured to control the main audio amplification section (24) to change the amplification factor of the main audio based on the volume operation by the user during the main audio and sub-audio input period.

6. The volume control apparatus according to claim 3,
wherein the control section (11) is configured to control the main audio amplification section (24) to change the amplification factor of the main audio based on the volume operation by the user during the main audio and sub-audio input period.

7. The volume control apparatus according to claim 5,
wherein when the amplification factor of the main audio by the main audio amplification section (24) and the master amplification section (32) becomes the fourth amplification factor which is higher than the third amplification factor through a volume operation by the user during the main audio and sub-audio input period, the control section (11) is configured to control the sub-audio amplification section (25) to increase the amplification factor of the sub-audio amplification section by a difference obtained by subtracting the third amplification factor from the fourth amplification factor and set the amplification factor of the sub-audio to the variable second amplification factor.

8. The volume control apparatus according to claim 6,
wherein when the amplification factor of the main audio by the main audio amplification section (24) and the master amplification section (32) becomes the fourth amplification factor which is higher than the third amplification factor through a volume operation by the user during the main audio and sub-audio input period, the control section (11) is configured to control the sub-audio amplification section (25) to increase the amplification factor of the sub-audio amplification section by a difference obtained by subtracting the third amplification factor from the fourth amplification factor and set the amplification factor of the sub-audio to the variable second amplification factor.

9. The volume control apparatus according to claim 1,
wherein during the main audio and sub-audio input period, the control section (11) is configured to control the sub-audio amplification section (25) to amplify the sub-audio with a fixed amplification factor when the amplification factor of the main audio is equal to or lower than the third amplification factor, and change the amplification factor of the sub-audio according to the change of the amplification factor of the main audio when the amplification factor of the main audio is the fourth amplification factor which is higher than the third amplification factor.

10. The volume control apparatus according to claim 3,
wherein during the main audio and sub-audio input period, the control section (11) is configured to control the sub-audio amplification section (25) to amplify the sub-audio with a fixed amplification factor when the amplification factor of the main audio is equal to or lower than the third amplification factor, and change the amplification factor of the sub-audio according to the change of the amplification factor of the main audio when the amplification factor of the main audio is the fourth amplification factor which is higher than the third amplification factor.

11. The volume control apparatus according to claim 5,
wherein during the main audio and sub-audio input period, the control section (11) is configured to control the sub-audio amplification section (25) to amplify the sub-audio with a fixed amplification factor when the amplification factor of the main audio is equal to or lower than the third amplification factor, and change the amplification factor of the sub-audio according to the change of the amplification factor of the main audio when the amplification factor of the main audio is the fourth amplification factor which is higher than the third amplification factor.

12. The volume control apparatus according to claim 6,
wherein during the main audio and sub-audio input period, the control section (11) is configured to control the sub-audio amplification section (25) to amplify the sub-audio with a fixed amplification factor when the amplification factor of the main audio is equal to or lower than the third amplification factor, and change the amplification factor of the sub-audio according to the change of the amplification factor of the main audio when the amplification factor of the main audio is the fourth amplification factor which is higher than the third amplification factor.

## Patentansprüche

1. Lautstärkesteuerungsvorrichtung, aufweisend:
einen Haupttonverstärkungsabschnitt (24), der konfiguriert ist, um einen eingegebenen Hauptton zu verstärken;
einen Untertonverstärkungsabschnitt (25), der konfiguriert ist, um einen eingegebenen Unterton zu verstärken;
einen Kombinierungsabschnitt (26), der konfiguriert ist, um eine Ausgabe des Haupttonverstärkungsabschnitts (24) und eine Ausgabe des Untertonverstärkungsabschnitts (25) zu kombinieren und auszugeben;
einen Masterverstärkungsabschnitt (32), der konfiguriert ist, um eine Ausgabe des Kombinierungsabschnitts zu verstärken; und
einen Steuerungsabschnitt (11), der konfiguriert ist, um eine erste Verstärkungsverarbeitung durchzuführen, um einen Verstärkungsfaktor des Haupttons basierend auf einem Lautstärkebetrieb durch einen Nutzer zu ändern, indem der Haupttonverstärkungsabschnitt und der Untertonverstärkungsabschnitt gesteuert werden, und um eine zweite Verstärkungsverarbeitung durchzuführen, um während einer Hauptton- und einer Unterton-Eingabeperiode, wenn der Verstärkungsfaktor des Haupttons gleich oder kleiner als ein dritter Verstärkungsfaktor ist, den Unterton mit einem ersten Verstärkungsfaktor zu verstärken, welcher größer als der dritte Verstärkungsfaktor ist, und um, wenn der Verstärkungsfaktor des Haupttons ein vierter Verstärkungsfaktor ist, welcher größer als der dritte Verstärkungsfaktor ist, den Unterton mit einem zweiten Verstärkungsfaktor zu verstärken, welcher größer als der erste Verstärkungsfaktor ist, und welcher sich in Abhängigkeit von dem vierten Verstärkungsfaktor ändert.

2. Lautstärkesteuerungsvorrichtung nach Anspruch 1,
wobei der Unterton einen Ton eines Klingeltons umfasst.

3. Lautstärkesteuerungsvorrichtung nach Anspruch 1,
wobei, als die erste Verstärkungsverarbeitung, der Steuerungsabschnitt (11) konfiguriert ist, um den Hauptton durch den Masterverstärkungsabschnitt (32) während einer Periode zu verstärken, in welcher nur der Hauptton eingegeben wird, und um den Verstärkungsfaktor des Masterverstärkungsabschnitts zu erhöhen und um den Verstärkungsfaktor des Haupttonverstärkungsabschnitts (24) während der Hauptton- und Unterton-Eingabeperiode zu verringern.

4. Lautstärkesteuerungsvorrichtung nach Anspruch 1,
wobei, wenn sich der Verstärkungsfaktor des Masterverstärkungsabschnitts (32) bei einem Start der Hauptton- und Unterton-Eingabeperiode erhöht, der Steuerungsabschnitt (11) konfiguriert ist, um den Haupttonverstärkungsabschnitt (24) zu steuern, um den Verstärkungsfaktor für den Hauptton zu verringern und um die Lautstärke des Haupttons beim Start der Hauptton- und Unterton-Eingabeperiode aufrechtzuerhalten.

5. Lautstärkesteuerungsvorrichtung nach Anspruch 1,
wobei der Steuerungsabschnitt (11) konfiguriert ist, um den Haupttonverstärkungsabschnitt (24) zu steuern, um den Verstärkungsfaktor des Haupttons basierend auf dem Lautstärkebetrieb durch den Nutzer während der Hauptton- und Unterton-Eingabeperiode zu ändern.

6. Lautstärkesteuerungsvorrichtung nach Anspruch 3,
wobei der Steuerungsabschnitt (11) konfiguriert ist, um den Haupttonverstärkungsabschnitt (24) zu steuern, um den Verstärkungsfaktor des Haupttons basierend auf dem Lautstärkebetrieb durch den Nutzer während der Hauptton- und Unterton-Eingabeperiode zu ändern.

7. Lautstärkesteuerungsvorrichtung nach Anspruch 5,
wobei, wenn der Verstärkungsfaktor des Haupttons durch den Haupttonverstärkungsabschnitt (24) und den Masterverstärkungsabschnitt (32) durch einen Lautstärkebetrieb durch den Nutzer während der Hauptton- und Unterton-Eingabeperiode der vierte Verstärkungsfaktor wird, welcher größer als der dritte Verstärkungsfaktor ist, der Steuerungsabschnitt (11) konfiguriert ist, um den Untertonverstärkungsabschnitt (25) zu steuern, um den Verstärkungsfaktor des Untertonverstärkungsabschnitts um eine Differenz zu erhöhen, die durch Subtrahieren des dritten Verstärkungsfaktors von dem vierten Verstärkungsfaktor erhalten wird, und um den Verstärkungsfaktor des Untertons auf den variablen zweiten Verstärkungsfaktor einzustellen.

8. Lautstärkesteuerungsvorrichtung nach Anspruch 6,
wobei, wenn der Verstärkungsfaktor des Haupttons durch den Haupttonverstärkungsabschnitt (24) und den Masterverstärkungsabschnitt (32) durch einen Lautstärkebetrieb durch den Nutzer während der Hauptton- und Unterton-Eingabeperiode der vierte Verstärkungsfaktor wird, welcher größer als der dritte Verstärkungsfaktor ist, der Steuerungsabschnitt (11) konfiguriert ist, um den Untertonverstärkungsabschnitt (25) zu steuern, um den Verstärkungsfaktor des Untertonverstärkungsabschnitts um eine Differenz zu erhöhen, die durch Subtrahieren des dritten Verstärkungsfaktors von dem vierten Verstärkungsfaktor erhalten wird, und um den Verstärkungsfaktor des Untertons auf den variablen zweiten Verstärkungsfaktor einzustellen.

9. Lautstärkesteuerungsvorrichtung nach Anspruch 1,
wobei, während der Hauptton- und Unterton-Eingabeperiode, der Steuerungsabschnitt (11) konfiguriert ist, um den Untertonverstärkungsabschnitt (25) zu steuern, um den Unterton mit einem fixierten Verstärkungsfaktor zu verstärken, wenn der Verstärkungsfaktor des Haupttons gleich oder kleiner als der dritte Verstärkungsfaktor ist, und um den Verstärkungsfaktor des Untertons gemäß der Änderung des Verstärkungsfaktors des Haupttons zu ändern, wenn der Verstärkungsfaktor des Haupttons der vierte Verstärkungsfaktor ist, welcher größer als der dritte Verstärkungsfaktor ist.

10. Lautstärkesteuerungsvorrichtung nach Anspruch 3,
wobei, während der Hauptton- und Unterton-Eingabeperiode, der Steuerungsabschnitt (11) konfiguriert ist, um den Untertonverstärkungsabschnitt (25) zu steuern, um den Unterton mit einem fixierten Verstärkungsfaktor zu verstärken, wenn der Verstärkungsfaktor des Haupttons gleich oder kleiner als der dritte Verstärkungsfaktor ist, und um den Verstärkungsfaktor des Untertons gemäß der Änderung des Verstärkungsfaktors des Haupttons zu ändern, wenn der Verstärkungsfaktor des Haupttons der vierte Verstärkungsfaktor ist, welcher größer als der dritte Verstärkungsfaktor ist.

11. Lautstärkesteuerungsvorrichtung nach Anspruch 5,
wobei, während der Hauptton- und Unterton-Eingabeperiode, der Steuerungsabschnitt (11) konfiguriert ist, um den Untertonverstärkungsabschnitt (25) zu steuern, um den Unterton mit einem fixierten Verstärkungsfaktor zu verstärken, wenn der Verstärkungsfaktor des Haupttons gleich oder kleiner als der dritte Verstärkungsfaktor ist, und um den Verstärkungsfaktor des Untertons gemäß der Änderung des Verstärkungsfaktors des Haupttons zu ändern, wenn der Verstärkungsfaktor des Haupttons der vierte Verstärkungsfaktor ist, welcher größer als der dritte Verstärkungsfaktor ist.

12. Lautstärkesteuerungsvorrichtung nach Anspruch 6,
wobei, während der Hauptton- und Unterton-Eingabeperiode, der Steuerungsabschnitt (11) konfiguriert ist, um den Untertonverstärkungsabschnitt (25) zu steuern, um den Unterton mit einem fixierten Verstärkungsfaktor zu verstärken, wenn der Verstärkungsfaktor des Haupttons gleich oder kleiner als der dritte Verstärkungsfaktor ist, und um den Verstärkungsfaktor des Untertons gemäß der Änderung des Verstärkungsfaktors des Haupttons zu ändern, wenn der Verstärkungsfaktor des Haupttons der vierte Verstärkungsfaktor ist, welcher größer als der dritte Verstärkungsfaktor ist.

## Revendications

1. Appareil de commande de volume, comprenant :
une section d'amplification d'audio principale (24), configurée de façon à amplifier une audio principale entrée ;
une section d'amplification de sous-audio (25), configurée de façon à amplifier une sous-audio entrée ;
une section de combinaison (26), configurée de façon à combiner une sortie de la section d'amplification d'audio principale (24) et une sortie de la section d'amplification de sous-audio (25), devant être délivrées en sortie ;
une section d'amplification maître (32), configurée de façon à amplifier une sortie de la section de combinaison ; et
une section de commande (11), configurée de façon à effectuer un premier traitement d'amplification de façon à changer un facteur d'amplification de l'audio principale en fonction d'une opération de volume par un utilisateur par la commande de la section d'amplification d'audio principale et de la section d'amplification de sous-audio, et à effectuer un deuxième traitement d'amplification de façon à amplifier, durant une période d'entrée d'audio principale et de sous-audio, lorsque le facteur d'amplification de l'audio principale est inférieur ou égal à un troisième facteur d'amplification, la sous-audio avec un premier facteur d'amplification qui est supérieur au troisième facteur d'amplification, et à amplifier, lorsque le facteur d'amplification de l'audio principale est un quatrième facteur d'amplification qui est supérieur au troisième facteur d'amplification, la sous-audio avec un deuxième facteur d'amplification qui est supérieur au premier facteur d'amplification et qui change en fonction du quatrième facteur d'amplification.

2. Appareil de commande de volume selon la revendication 1,
dans lequel la sous-audio comprend une audio d'une tonalité de sonnerie.

3. Appareil de commande de volume selon la revendication 1,
dans lequel, à titre de premier traitement d'amplification, la section de commande (11) est configurée de façon à amplifier l'audio principale par l'intermédiaire de la section d'amplification maître (32) durant une période pendant laquelle seule l'audio principale est entrée, et à augmenter le facteur d'amplification de la section d'amplification maître et à réduire le facteur d'amplification de la section d'amplification audio principale (24) durant la période d'entrée d'audio principale et de sous-audio.

4. Appareil de commande de volume selon la revendication 1,
dans lequel, lorsque le facteur d'amplification de la section d'amplification maître (32) augmente à un début de la période d'entrée d'audio principale et de sous-audio, la section de commande (11) est configurée de façon à commander la section d'amplification d'audio principale (24) de façon à réduire le facteur d'amplification pour l'audio principale et à maintenir le volume de l'audio principale au début de la période d'entrée d'audio principale et de sous-audio.

5. Appareil de commande de volume selon la revendication 1,
dans lequel la section de commande (11) est configurée de façon à commander la section d'amplification d'audio principale (24) de façon à changer le facteur d'amplification de l'audio principale en fonction de l'opération de volume par l'utilisateur durant la période d'entrée d'audio principale et de sous-audio.

6. Appareil de commande de volume selon la revendication 3,
dans lequel la section de commande (11) est configurée de façon à commander la section d'amplification d'audio principale (24) de façon à changer le facteur d'amplification de l'audio principale en fonction de l'opération de volume par l'utilisateur durant la période d'entrée d'audio principale et de sous-audio.

7. Appareil de commande de volume selon la revendication 5,
dans lequel, lorsque le facteur d'amplification de l'audio principale par la section d'amplification d'audio principale (24) et la section d'amplification maître (32) devient le quatrième facteur d'amplification, qui est supérieur au troisième facteur d'amplification, par l'intermédiaire d'une opération de volume par l'utilisateur durant la période d'entrée d'audio principale et de sous-audio, la section de commande (11) est configurée de façon à commander la section d'amplification de sous-audio (25) de façon à augmenter le facteur d'amplification de la section d'amplification de sous-audio d'une différence obtenue par la soustraction du troisième facteur d'amplification à partir du quatrième facteur d'amplification, et à établir le facteur d'amplification de la sous-audio au deuxième facteur d'amplification variable.

8. Appareil de commande de volume selon la revendication 6,
dans lequel, lorsque le facteur d'amplification de l'audio principale par la section d'amplification d'audio principale (24) et la section d'amplification maître (32) devient le quatrième facteur d'amplification, qui est supérieur au troisième facteur d'amplification, par l'intermédiaire d'une opération de volume par l'utilisateur durant la période d'entrée d'audio principale et de sous-audio, la section de commande (11) est configurée de façon à commander la section d'amplification de sous-audio (25) de façon à augmenter le facteur d'amplification de la section d'amplification de sous-audio d'une différence obtenue par la soustraction du troisième facteur d'amplification à partir du quatrième facteur d'amplification, et à établir le facteur d'amplification de la sous-audio au deuxième facteur d'amplification variable.

9. Appareil de commande de volume selon la revendication 1,
dans lequel, durant la période d'entrée d'audio principale et de sous-audio, la section de commande (11) est configurée de façon à commander la section d'amplification de sous-audio (25) de façon à amplifier la sous-audio avec un facteur d'amplification fixe lorsque le facteur d'amplification de l'audio principale est inférieur ou égal au troisième facteur d'amplification, et à changer le facteur d'amplification de la sous-audio en fonction du changement du facteur d'amplification de l'audio principale lorsque le facteur d'amplification de l'audio principale est le quatrième facteur d'amplification, qui est supérieur au troisième facteur d'amplification.

10. Appareil de commande de volume selon la revendication 3,
dans lequel, durant la période d'entrée d'audio principale et de sous-audio, la section de commande (11) est configurée de façon à commander la section d'amplification de sous-audio (25) de façon à amplifier la sous-audio avec un facteur d'amplification fixe lorsque le facteur d'amplification de l'audio principale est inférieur ou égal au troisième facteur d'amplification, et à changer le facteur d'amplification de la sous-audio en fonction du changement du facteur d'amplification de l'audio principale lorsque le facteur d'amplification de l'audio principale est le quatrième facteur d'amplification, qui est supérieur au troisième facteur d'amplification.

11. Appareil de commande de volume selon la revendication 5,
dans lequel, durant la période d'entrée d'audio principale et de sous-audio, la section de commande (11) est configurée de façon à commander la section d'amplification de sous-audio (25) de façon à amplifier la sous-audio avec un facteur d'amplification fixe lorsque le facteur d'amplification de l'audio principale est inférieur ou égal au troisième facteur d'amplification, et à changer le facteur d'amplification de la sous-audio en fonction du changement du facteur d'amplification de l'audio principale lorsque le facteur d'amplification de l'audio principale est le quatrième facteur d'amplification, qui est supérieur au troisième facteur d'amplification.

12. Appareil de commande de volume selon la revendication 6,
dans lequel, durant la période d'entrée d'audio principale et de sous-audio, la section de commande (11) est configurée de façon à commander la section d'amplification de sous-audio (25) de façon à amplifier la sous-audio avec un facteur d'amplification fixe lorsque le facteur d'amplification de l'audio principale est inférieur ou égal au troisième facteur d'amplification, et à changer le facteur d'amplification de la sous-audio en fonction du changement du facteur d'amplification de l'audio principale lorsque le facteur d'amplification de l'audio principale est le quatrième facteur d'amplification, qui est supérieur au troisième facteur d'amplification.
